# EUROPEAN PATENT APPLICATION

(11) **EP 0 831 562 A1**
(43) Date of publication of application: **25.03.1998**
(21) Application number: 97113471.3
(22) Date of filing: 05.08.1997
(51) Int. Cl.: H01R 13/66

(54) **Electronic device package**

(30) Priority: 23.09.1996 US 710797
(71) Applicant: MOTOROLA, INC., Schaumburg, IL 60196 (US)
(72) Inventor: Specks,Johannes, 81929 Munich (DE); Cotney, Garland Douglas, Tempe, Arizona 85283 (US); Monroe, Conrad, 85661 Forstinning (DE)
(74) Representative: Gibson, Sarah Jane

(57) **Abstract**

An electronic device package (10) includes an electronic device (20) and an electrical coupling (40) connected to the electronic device (20) and arranged for providing electrical coupling to an external device (80). The device housing (50) is arranged to encapsulate the electronic device, and also comprises an integral collar (55) arranged about the electrical coupling (40) which is arranged to provide mechanical coupling to the external device (80) when said external device (80) is electrically coupled to the connector (40).

## Description

### Field of the Invention

This invention relates to electronic device packages and particularly but not exclusively to electronic device packages incorporating mechanical connections.

### Background of the Invention

Conventional electronic devices, such as semiconductor modules may include diverse mechanical, electrical and electronic components, which are all assembled on a printed circuit board (PCB). A number of different materials and assembly steps are required to build a device. A typical arrangement may comprise a PCB, integrated circuit lead frame, socket connector lead frame, integrated circuit package mould and socket connector mould.

A problem with the above arrangement is the number of components and assembly steps required to manufacture the device.

It is known to combine the integrated circuit lead frame and socket connector lead frame into a single composite lead frame, made from a single metal plate. This has the further benefit that the PCB can be eliminated, since the connection between the integrated circuit and the socket connector is now achieved inherently via the single lead frame.

However, further reduction in the number of components and assembly steps is desirable, to reduce manufacturing costs and increase efficiency.

This invention seeks to provide an electronic device package which addresses the above mentioned issues.

### Summary of the Invention

According to the present invention there is provided an electronic device package comprising: an electronic device; electrical coupling means connected to the electronic device and arranged for providing electrical coupling to an external device; and, encapsulation means arranged to encapsulate the electronic device, wherein the encapsulation means also comprises an integral formation arranged about the electrical coupling means for providing mechanical coupling to the external device when said external device is electrically coupled to the electrical coupling means.

Preferably the integral formation is a socket, and the external device forms a plug resiliently engageable with the socket. Alternatively the integral formation is preferably a plug, and the external device forms a socket resiliently engageable with the plug.

Preferably the integral formation includes guide means for providing a guide to the external device. The integral formation preferably includes locking means for locking the external device in place when coupled thereto.

In this way, a further reduction in the number of components and assembly steps is achieved, manufacturing costs are reduced and efficiency increases.

### Brief Description of the Drawing(s)

An exemplary embodiment of the invention will now be described with reference to the drawing in which:
FIG.1 shows, in plan view, a preferred embodiment of an electronic device package in accordance with the invention.
FIG.2 shows a side view of the embodiment of FIG.1, including a plug.

### Detailed Description of a Preferred Embodiment

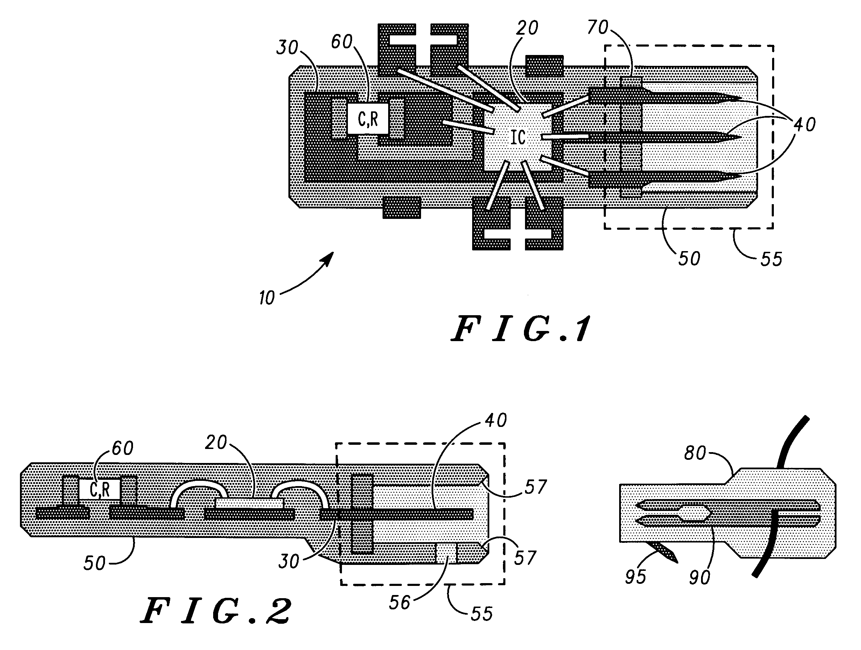

Referring to FIGs.1 and 2, there is shown an electronic device package 10 comprising an integrated circuit 20, a lead frame 30, a connector 40, a housing 50, and passive components 60.

The integrated circuit 20, passive components 60 and connector 40 are all electrically interconnected by the lead frame 30, the connections being achieved by conventional wire bond techniques. The connector 40 may actually be formed as part of the lead frame 30, as shown in FIG.1.

The connector 40 has male protrusions designed to provide electrical coupling to an external plug 80, which comprises a female member 90 arranged to co-operate with the male protrusions of the connector 40. The female member 90 includes a tongue 95, to be further described below.

The electronic device package 10 may be a module of a motor vehicle system, with the plug 80 being part of a wiring harness of the motor vehicle, thus providing connectivity between the electronic device package 10, other modules and a main unit of the motor vehicle system.

The housing 50 has two functions. The first function is that of encapsulation, for encapsulating the integrated circuit 20, lead frame 30 and passive components 60. The second function is performed by a collar 55, which surrounds the connector 40, and is arranged to co-operate with the plug 80 in a manner to be further described below.

The collar 55 is formed so as to mechanically engage the plug 80 whilst the female member 90 is coupled to the male protrusions of the connector 40.

A strength member 70, formed by insulation material, separates the connector 40 from the internally encapsulated components (lead frame 30 integrated circuit 20), and provides protection for these components from excessive physical strain caused by the plug 80. The strength member 70 also adds further insulation protection for the encapsulated components.

The collar 55 includes a locking cavity 56, arranged to resiliently engage the tongue 95 of the female member 90, and guides 57, for guiding the plug 80 into engagement with the collar 55.

It will be appreciated that alternative embodiments to the one described above are possible. For example, the male protrusions and female member 90 could be reversed, such that the male protrusions form part of the plug 80 and the female member forms part of the electronic device package 10.

Furthermore, the collar 55 could be arranged to locate within the plug 80, which would correspondingly include means for surrounding the collar.

Additionally, the wire bond techniques described above could be replaced by flip-chip techniques, for electrically connecting the integrated circuit 20, passive components 60, connector 40, and lead frame 30.

## Claims

1. An electronic device package comprising:
an electronic device;
electrical coupling means connected to the electronic device and arranged for providing electrical coupling to an external device;
encapsulation means arranged to encapsulate the electronic device,
wherein the encapsulation means also comprises an integral formation arranged about the electrical coupling means for providing mechanical coupling to the external device when said external device is electrically coupled to the electrical coupling means.

2. An electronic device package as claimed in claim 1 wherein the integral formation is a socket, and the external device forms a plug resiliently engageable with the socket.

3. An electronic device package as claimed in claim 1 wherein the integral formation is a plug, and the external device forms a socket resiliently engageable with the plug.

4. An electronic device package as claimed in any preceding claim wherein the integral formation includes guide means for providing a guide to the external device.

5. An electronic device package as claimed in any preceding claim wherein the integral formation includes locking means for locking the external device in place when coupled thereto.

6. An electronic device package as claimed in any preceding claim wherein the integral formation includes a strength member, which substantially prevents damage to internal elements of the device.
